# EUROPÄISCHE PATENTANMELDUNG

(11) **EP 1 605 593 A2**
(43) Veröffentlichungstag der Anmeldung: **14.12.2005**
(21) Anmeldenummer: 05011996.5
(22) Anmeldetag: 03.06.2005
(51) Int. Cl.: H03K 17/955, E03C 1/05

(54) **Schaltungsanordnung zum Betreiben einer Sanitärarmatur**

(30) Priorität: 08.06.2004 DE 102004027948
(71) Anmelder: HANSA METALLWERKE AG, 70567 Stuttgart (DE)
(72) Erfinder: Kunkel, Horst, 70567 Stuttgart (DE)
(74) Vertreter: Ostertag, Ulrich

(57) **Zusammenfassung**

Eine Schaltungsanordnung zum Betreiben einer Sanitärarmatur umfasst mindestens einen kapazitiven Sensor (110), der bei Annäherung eines Gegenstandes als Ausgangssignal einen Impuls erzeugt. Dieser wird einer Auswertschaltung (100) zugeführt, die einen programmierbaren Prozessor und einen Speicher umfasst, in dem unterschiedliche Betriebsarten und unterschiedliche Betriebsparameter speicherbar sind. Die Auswertschaltung (100) kann einerseits in einem Programmiermodus arbeiten, in dem sie eine von dem kapazitiven Sensor (110) zugeführte Impulsfolge als Code für eine bestimmte im Speicher abgespeicherte Betriebsart und/oder für mindestens einen bestimmten im Speicher abgespeicherten Betriebsparameter erkennt und diese Betriebsart und/oder diesen Betriebsparameter abruft. Oder die Auswertschaltung (100) arbeitet in einem Normalmodus, in dem sie die ihr von dem kapazitiven Sensor (110) zugeführte Impulsfolge auf das Vorliegen eines vorgegebenen Impulsfolge-Codes untersucht und in den Programmiermodus wechselt, wenn der Impulsfolge-Code vorliegt.

## Beschreibung

Die Erfindung betrifft eine Schaltungsanordnung zum Betreiben einer Sanitärarmatur mit
a) mindestens einem kapazitiven Sensor, der bei Annäherung eines Gegenstandes als Ausgangssignal einen Impuls erzeugt;
b) einer Auswertschaltung, welcher das Ausgangssignal des kapazitiven Sensors zuführbar ist und die umfasst
   ba) einen programmierbaren Prozessor;
   bb) einen Speicher, auf den der Prozessor zugreifen kann und in dem unterschiedliche Betriebsarten und/oder unterschiedliche Betriebsparameter speicherbar sind;
c) einer von der Auswertschaltung angesteuerten Treiberschaltung für mindestens ein den Wasserstrom durch die Sanitärarmatur bestimmendes Magnetventil.

Mit zunehmenden Anforderungen an den Komfort werden Sanitärarmaturen immer beliebter, die berührungslos oder jedenfalls ohne Betätigung eines mechanischen Schalters bedient werden können. Auch unter hygienischen Gesichtspunkte sind insbesondere berührungslos arbeitende Sanitärarmaturen von großem Vorteil. Als Sensoren, welche die Annäherung eines Gegenstandes entweder völlig berührungslos oder jedenfalls ohne Auslösen einer mechanischen Bewegung erkennen, sind hauptsächlich zwei Arten gebräuchlich: Am häufigsten eingesetzt wird die sog. Infrarot-Reflexionslichtschranke, bei welcher der Sensor einen Infrarot-Strahl aussendet und die Anwesenheit einer Person dadurch erkennt, daß der an dieser Person reflektierte Lichtstrahl erfasst wird. Weniger gebräuchlich sind derzeit kapazitive Sensoren, die jedoch aus Kostengründen zunehmend interessant werden.

Die Schaltungsanordnungen, mit denen die Sanitärarmatur auf die geschilderte Weise berührungslos oder jedenfalls ohne Betätigung eines mechanischen Schalters betrieben werden können, sollten für unterschiedliche Arten von Sanitärarmaturen und für unterschiedliche Einsatzbedingungen geeignet sein. Unterschiedliche Arten von Sanitärarmaturen, z. B. also Waschtischarmaturen, Urinale oder Duschen, müssen in unterschiedlichen Betriebsarten angesteuert werden. Unter "Betriebsarten" werden hier bestimmte Abfolgen der Öffnung des Magnetventils nach dem ersten Auftreten eines Signales des Sensors verstanden. So können beispielsweise verschiedene Wartezeiten eingehalten werden, bevor ein Auslösen erfolgt, und die Dauer der Auslösung kann unterschiedlich sein. Darüber hinaus kann es wünschenswert sein, für jeden Einzelfall der Installation der Sanitärarmatur die Betriebsparameter, mit denen die Sanitärarmatur arbeitet, wählen zu können. Unter "Betriebsparameter" wird hier insbesondere der Wert einer Größe wie z. B. der die Sanitärarmatur in einer bestimmten Zeiteinheit durchfließenden Wassermenge oder der Temperatur des fließenden Wassers verstanden.

Bei Schaltungsanordnungen, die mit Infrarot-Lichtschranken arbeiten, ist es verhältnismäßig einfach möglich, eine Umprogrammierung je nach der gewünschten Betriebsart und/oder den gewünschten Betriebsparameter vorzunehmen. Hierfür kann eine Art Fernbedienung eingesetzt werden, die selbst einen kodierten Lichtstrahl aussendet und über das Lichteintrittsfenster des Sensors mit der Schaltungsanordnung kommuniziert. Auf diese Weise kann die Schaltungsanordnung jederzeit vor Ort an die dort vorgefundenen Gegebenheiten angepasst werden, ohne daß unmittelbarer elektrischer Zugang zu ihr gewonnen werden muß.

Eine derartige Umprogrammierung vor Ort war jedoch bisher mit Schaltungsanordnungen, die von kapazitiven Sensoren Gebrauch machen, nicht möglich.

Aufgabe der vorliegenden Erfindung ist es, eine Schaltungsanordnung der eingangs genannten Art so auszugestalten, daß ohne direkten elektrischen Zugang zum Prozessor ein Wechsel der Betriebsart und/oder mindestens eines Betriebsparameters möglich ist.

Diese Aufgabe wird erfindungsgemäß dadurch gelöst, daß
d) die Auswertschaltung in zwei unterschiedlichen Betriebsmoden arbeiten kann, nämlich
   da) in einem Programmiermodus, in dem sie eine von dem kapazitiven Sensor zugeführte Impuls- folge als Code für eine bestimmte im Speicher abgespeicherte Betriebsart und/oder für min- destens einen bestimmten im Speicher abge- speicherten Betriebsparameter erkennt und diese Betriebsart und/oder diesen Betriebs- parameter aktiviert;
   db) in einem Normalmodus, in dem sie die ihr von dem kapazitiven Sensor zugeführte Impulsfolge auf das Vorliegen eines vorgegebenen Impuls- folge-Codes untersucht und in den Programmier- modus umwechselt, wenn der Impulsfolge-Code vorliegt, während sie bei einem Impuls oder einer Impulsfolge, die nicht dem Impulsfolge- Code entspricht, die Treiberschaltung entspre- chend der derzeit aktiven Betriebsart und den derzeit aktiven Betriebsparametern ansteuert.

Erfindungsgemäß muß also der Benutzer, der die Schaltungsanordnung in irgendeiner Weise umprogrammieren will, an dem kapazitiven Sensor bewußt eine ganz bestimmte Impulsfolge eingeben, die als Code für den Wechsel in den Programmiermodus verstanden wird. Im Normalmodus überwacht die Auswertschaltung ständig, ob dieser Code auftritt. Ist dies nicht der Fall, wird ein eingegangener Impuls oder eine eingegangene Impulsfolge in normaler Weise in eine entsprechende Ansteuerung der Treiberschaltung und damit ein Öffnen des Magnetventils umgesetzt.

Nur wenn sich die erfasste Impulsfolge als Impulsfolge-Code herausstellt, wechselt die Schaltungsanordnung in den Programmiermodus über. In diesem Programmiermodus werden eingehende Impulsfolgen daraufhin analysiert, ob sie einem in dem Speicher abgelegten Code entsprechen. Ist dies der Fall, wird die entsprechende Betriebsart bzw. der entsprechende Betriebsparameter aktiviert und die Schaltungsanordnung kehrt mit dieser neuen Betriebsart und/oder diesem neuen Betriebsparameter in den Normalmodus zurück.

Wird die im Programmiermodus eingegebene Impulsfolge nicht erkannt, wird ein Fehlersignal erzeugt; die Schaltungsanordnung kehrt ebenfalls in den Normalmodus zurück, wobei jedoch die zuvor aktivierte Betriebsart und die zuvor aktivierten Betriebsparameter erhalten bleiben.

Der Impulsfolge-Code besteht zweckmäßigerweise in einer bestimmten Anzahl von in einem bestimmten Zeitintervall auftretenden Impulsen des kapazitiven Sensors. Der Benutzer muß also innerhalb dieses Zeitintervalls durch entsprechend häufige Annäherung beispielsweise eines Fingers an den kapazitiven Sensor die fragliche Zahl von Impulsen erzeugen, wenn er den Übergang der Auswertschaltung in den Programmiermodus wünscht.

Zweckmäßigerweise sind Mittel vorgesehen, welche ausschließen, daß eine zufällige von dem kapazitiven Sensor erzeugte Impulsfolge als Impulsfolge-Code mißverstanden wird. Ein solches Mißverständnis ist von vornherein - also ohne zusätzliche Mittel - um so unwahrscheinlicher, um so größer die als Impulsfolge-Code gewählte Anzahl von Impulsen ist. Der Erhöhung dieser Zahl ist jedoch aus Praktikabilitätsgründen eine Grenze gesetzt, so daß zusätzliche Mittel, welche einen fälschlichen Wechsel in den Programmiermodus verhindern, angezeigt sind.

Diese zusätzlichen Mittel können in einer Programmierung der Auswertschaltung bestehen, bei welcher nach dem Zählen der von dem kapazitiven Sensor innerhalb des Zeitintervalls empfangenen Impulse mindestens eine Wartezeit eingehalten wird, in welcher das Auftreten eines weiteren Impulses untersucht wird, wobei
a) beim Auftreten eines weiteren Impulses die Treiberschaltung angesteuert wird;
b) beim Ausbleiben eines weiteren Impulses in den Programmiermodus übergegangen wird.

Bei dieser Art, ein Fehlauslösen des Programmiermodus zu verhindern, wird davon ausgegangen, daß bei einer bewußten, willentlichen Erzeugung des Impulsfolge-Codes tatsächlich nur die entsprechende Anzahl von Impulsen erzeugt wird. Folgt nach Empfang dieser Zahl von Impulsen jedoch ein weiterer Impuls, wird dies von der Auswertschaltung so verstanden, daß es sich um eine zufällige Impulsfolge handelt; diese führt dann nicht zum Wechsel in den Programmiermodus sondern zum Ansteuern der Treiberschaltung.

Die Mittel, durch die ein falsches Umschalten in den Programmiermodus verhindert werden, können auch in einer Programmierung der Auswertschaltung bestehen, bei welcher eine Wartezeit eingeschoben wird, in welcher das Auftreten eines Impulses überwacht wird, wobei
a) bei Auftreten eines weiteren Impulses in den Programmiermodus übergegangen wird;
b) bei Ausbleiben eines Impulses die Treiberschaltung ausgelöst wird.

Hier wird das ungewollte Wechseln der Schaltungsanordnung in den Programmiermodus dadurch vermieden, daß der Benutzer die gewollte Eingabe des Impulsfolge-Codes durch einen weiteren Impuls bestätigen muß, die innerhalb eines bestimmten Zeitfensters zu erfolgen hat. Bleibt dieser Bestätigungsimpuls aus, wird die zuvor festgestellte Impulsfolge als zufällig verstanden und zum Ansteuern der Treiberschaltung genutzt.

Die Mittel, welche eine falsche Umschaltung der Auswertschaltung in den Programmiermodus verhindern, können auch einen zweiten kapazitiven Sensor umfassen, der bei Annäherung eines Gegenstandes als Ausgangssignal einen Impuls abgibt, wobei die Auswertschaltung so programmiert ist, daß sie in den Programmiermodus übergeht, wenn innerhalb einer bestimmten Wartezeit nach Erkennen des Impulsfolge-Codes ein Impuls des zweiten kapazitiven Sensors auftritt, während sie die Treiberschaltung ansteuert, wenn ein solcher Impuls des zweiten kapazitiven Sensors ausbleibt.

Die Logik dabei ist also die, daß die Eingabe des Impulsfolge-Codes am ersten Sensor durch einen am zweiten Sensor erzeugten Impuls bestätigt werden muß. Der zweite Sensor ist dabei geometrisch so angeordnet, daß er nicht versehentlich bei der Benutzung der Sanitärarmatur bzw. bei der Betätigung des ersten Sensors auslöst, sondern daß eine bewusste Annäherung zum Auslösen erforderlich ist.

Zweckmäßigerweise sind die verschiedenen Betriebsarten und/oder die verschiedenen Betriebsparameter im Speicher unter einer Zahl als Adresse abgespeichert, wobei die Zahl der im Programmiermodus unmittelbar hintereinander auftretenden Impulse des kapazitiven Sensors als Code für das Auslesen der unter dieser Zahl abgespeicherten Betriebsart und/oder des unter dieser Zahl abgespeicherten Betriebsparameters verstanden wird.

Die Auswertschaltung sollte beim Übergang in den Programmiermodus ein Quittierungssignal erzeugen, damit der Benutzer erkennen kann, daß die Auswertschaltung nunmehr zum Programmieren bereit ist.

Außerdem sollte die Auswertschaltung im Programmiermodus beim Erkennen einer für eine bestimmte Betriebsart und/oder einen bestimmten Betriebsparameter codierenden Impulsfolge ein Quittierungssignal erzeugen. Der Benutzer weiß dann beim Auftreten des Quittierungssignales, daß der Programmierungsvorgang erfolgreich abgeschlossen ist.

Das Quittierungssignal kann in einer bestimmten Ansteuerung der Treiberschaltung bestehen. Je nach dem, was angezeigt werden soll, kann eine unterschiedliche Zahl oder eine unterschiedliche Dauer von Öffnungen des Magnetventiles herbeigeführt werden, was der Benutzer an einem entsprechenden Strömen des Wassers erkennt. Besondere Anzeigemittel für das Quittierungssignal sind in diesem Falle nicht erforderlich.

Ausführungsbeispiele der Erfindung werden nachstehend anhand der Zeichnung näher erläutert; es zeigen
- Figur 1: ein Blockschaltbild einer ersten Ausführungsform einer Schaltungsanordnung zum berührungslosen Betreiben einer Sanitärarmatur;
- Figur 2: ein zweites Ausführungsbeispiel einer solchen Schaltungsanordnung;
- Figur 3: das Ablaufdiagramm, nach dem die Schaltungsanordnung der Figur 1 betrieben wird;
- Figur 4: das Ablaufdiagramm, nach dem die Schaltungsanordnung der Figur 2 betrieben wird.

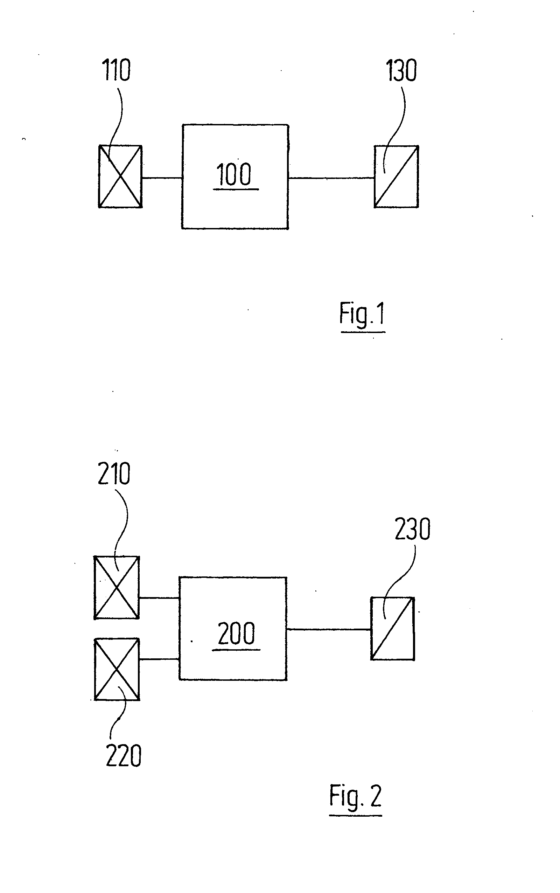

Zunächst wird auf die Figur 1 Bezug genommen. Die hier dargestellte Schaltungsanordnung kann zum Betreiben einer beliebigen Sanitärarmatur, beispielsweise einer Waschtischarmatur, eines Urinals oder auch einer Dusche eingesetzt werden. Sie umfasst einen kapazitiven Sensor 110, eine Auswertschaltung 100 sowie eine Treiberschaltung 130, mit welcher mindestens ein einen Wasserstrom steuerndes Magnetventil bestromt werden kann.

Die Auswertschaltung 100 umfasst einen programmierbaren Prozessor sowie einen Speicher, in dem verschiedene Betriebsarten und Betriebsparameter abgespeichert sind, in denen die Schaltungsanordnung betrieben werden kann. Unter "Betriebsart" wird hier eine bestimmte Abfolge von Vorgängen verstanden, die abgewickelt wird, wenn der kapazitive Sensor 110 die Anwesenheit eines Benutzers feststellt und einen Wasserstrom auslösen soll. Bei diesen Vorgängen kann es sich um Wartezeiten, Spülzeiten oder Spülfolgen handeln. Unter "Betriebsparameter" werden Größen wie die Dauer von Wartezeiten, von Spülimpulsen, Werte von Temperaturen, Strömungsmengen pro Zeiteinheit oder dgl. verstanden.

Die Auswertschaltung 100 kann in zwei verschiedenen Betriebsmoden arbeiten: Im "Normalmodus" erkennt sie in weiter unten ausführlicher beschriebener Weise die Anwesenheit eines Ausgangssignales des kapazitiven Sensors 110, prüft, ob es sich hierbei um einen bestimmten, den Wechsel der Betriebsart auslösenden Code handelt, löst, falls dies nicht der Fall ist, entsprechend dem jeweils aktiven Programm das Magnetventil 130 aus und schaltet, falls das Ausgangssignal des kapazitiven Sensors 110 als entsprechender Code verstanden worden ist, in einen "Programmiermodus" um.

Wird die Auswertschaltung 100 im Programmiermodus betrieben, werden die in diesem Falle willentlich am kapazitiven Sensor 110 erzeugten Signale in ebenfalls weiter unten ausführlich beschriebener Weise zur Wahl eines neuen Programmes, also ggf. zur Wahl einer anderen Betriebsart oder anderer Betriebsparameter genutzt.

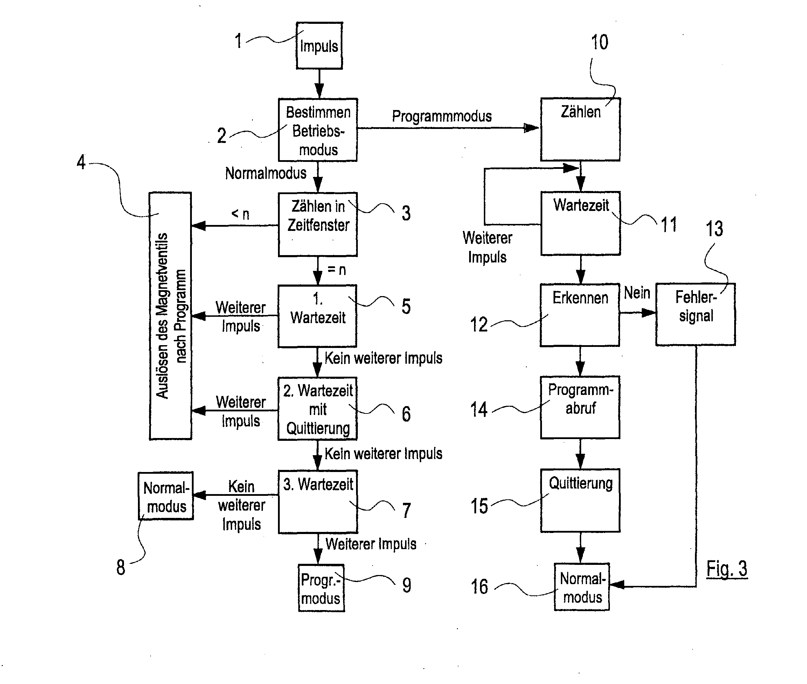

Einzelheiten der Programmierung der Auswertschaltung 100 sind in Figur 3 zu erkennen, die ein Ablaufdiagramm der verschiedenen Vorgänge darstellt.

Im Schritt 1 tritt ein Impuls, also ein Ausgangssignal des kapazitiven Sensors 110, auf und wird der Auswertschaltung 100 zugeführt. Je nach dem, ob diese sich im Normalmodus oder im Programmiermodus befindet, geschieht die Weiterverarbeitung unterschiedlich. Zunächst sei angenommen, daß sich die Auswertschaltung 100 im Normalmodus befindet. Das Programm schreitet in diesem Falle zum Programmschritt 3 weiter. In diesem wird innerhalb eines bestimmten Zeitfensters geprüft, ob eine bestimmte Zahl n, beispielsweise 4, Impulse eingehen. Die Zahl n wird so gewählt, daß normalerweise das Auftreten so vieler Impulse im fraglichen Zeitfenster nicht wahrscheinlich ist, daß also das Auftreten dieser Impulse als Zeichen für eine willentliche Betätigung des kapazitiven Sensors 110 verstanden werden darf. Wird innerhalb des Zeitfensters die Zahl n nicht erreicht, geht das Programm zu Programmschritt 4 über und löst nach dem derzeit aktiven Programm die Treiberschaltung 130 aus, was zu einem entsprechenden Wasserstrom aus der Sanitärarmatur führt.

Wird dagegen im Schritt 3 innerhalb des vorgegebenen Zeitfensters die Zahl n von Impulsen des kapazitiven Sensors 110 erreicht, wechselt das Programm der Auswertschaltung 100 zum Schritt 5. In diesem Schritt 5 wird eine gewisse Wartezeit eingehalten, in welcher geprüft wird, ob noch ein weiterer Impuls eingeht. Ist dies der Fall, wird die erfasste Impulsfolge nicht als Ergebnis einer willentlichen Betätigung des kapazitiven Sensors 110 sondern als zufällig gewertet. Tritt also innerhalb der ersten Wartezeit im Schritt 5 ein weiterer Impuls auf, wechselt das Programm vom Schritt 5 zum Schritt 4, in dem in oben schon geschilderter Weise die Treiberschaltung 130 in Funktion gesetzt wird.

Wird jedoch während der ersten Wartezeit im Schritt 5 kein weiterer Impuls festgestellt, wird im Schritt 6 eine zweite Wartezeit eingeleitet. Gleichzeitig wird ein Quittierungssignal erzeugt, beispielsweise in der Form, daß das oder die Magnetventile während der zweiten Wartezeit geöffnet werden. In der zweiten Wartezeit wird erneut geprüft, ob ein weiterer Impuls auftritt. Ist dies der Fall, wird dies ähnlich wie im Schritt 5 als nicht willentliche Betätigung des kapazitiven Sensors 110 verstanden; durch Wechsel zum Schritt 4 löst die Auswertschaltung 100 die Funktion der Treiberschaltung 130 aus.

Bleibt ein weiterer Impuls dagegen während der zweiten Wartezeit aus, wird eine dritte Wartezeit begonnen (Schritt 7). Auch diese dient im wesentlichen dazu, Sicherheit darüber zu erlangen, daß die festgestellte Impulsfolge tatsächlich die Konsequenz einer willentlichen Betätigung des kapazitiven Sensors 110 ist, mit welcher der Wechsel in den Programmiermodus beabsichtigt ist. Dieser Wunsch des Benutzers muß innerhalb der dritten Wartezeit durch einen weiteren Impuls, also eine weitere willentliche Annäherung an den kapazitiven Sensor 110, bestätigt werden. Tritt innerhalb der dritten Wartezeit kein derartiger Bestätigungsimpuls auf, wechselt das Programm vom Schritt 7 zum Schritt 8, kehrt also in den Normalmodus zurück.

Wird ein Bestätigungsimpuls innerhalb der dritten Wartezeit erhalten, so geht die Auswertschaltung 100 in den Programmiermodus über.

Bei den ab sofort in der Auswertschaltung 100 eingehenden Impulsen des kapazitiven Sensors 110 sind die Abläufe wie folgt:

Im Schritt 2 wird nunmehr das Vorliegen des Programmiermodus festgestellt. Das Programm geht zum Schritt 10, in welchem die Zahl von nunmehr eingegebenen Impulsen ermittelt wird. Das Programm wartet im Schritt 11 eine gewisse Zeit zu, um sicherzustellen, daß der Benutzer die volle Zahl gewünschter Impulse eingegeben hat. Wird innerhalb der Wartezeit des Schrittes 11 ein weiterer Impuls erhalten, wird die Wartezeit des Schrittes 11 erneut durchlaufen. Ohne einen solchen weiteren Impuls dagegen wird im Programmschritt 12 die Zahl der festgestellten Impulse mit verschiedenen Zahlen verglichen, die im Speicher der Auswertschaltung 100 abgespeichert sind. Jede dieser Zahlen steht für eine bestimmte Betriebsart bzw. für einen bestimmten Wert eines Betriebsparameters, mit der bzw. dem die Sanitärarmatur betrieben werden soll.

Erkennt die Auswertschaltung 100, daß die festgestellte Zahl von Impulsen mit einer im Speicher abgespeicherten Zahl übereinstimmt, wird in Schritt 14 das entsprechende Programm abgerufen. Im Schritt 15 wird ein den positiven Abschluß des Programmierverfahrens anzeigendes Quittierungssignal erzeugt. Bei diesem kann es sich wieder um einen für eine bestimmte Zeit andauernden Wasserfluss handeln. Nunmehr kehrt das Programm in den Normalmodus (Schritt 16) zurück, der nunmehr allerdings in der neuen Betribesart bzw. dem neuen Wert des Betriebsparameters betrieben wird.

Erkennt die Auswertschaltung 100 im Schritt 12 die festgestellte Zahl von Impulsen nicht als eine der in ihr abgespeicherten Zahlen, so wird ein Fehlersignal erzeugt (Schritt 13) und das Programm kehrt im Schritt 16 in den Normalmodus zurück, allerdings in der bereits zuvor aktiven Betriebsart bzw. mit den zuvor aktiven Werten der Betriebsparameter.

Die oben beschriebene und in Figur 1 dargestellte Schaltungsanordnung kommt mit einem einzigen kapazitiven Sensor 110 aus; um sicherzustellen, daß kein unbeabsichtigter Übergang in den Programmiermodus erfolgt, sind die verschiedenen, oben im einzelnen beschriebenen Wartezeiten der Schritte 5, 6 und 7 vorgesehen.

Das in Figur 2 dargestellte Ausführungsbeispiel einer Schaltungsanordnung, mit welcher ebenfalls die unterschiedlichsten Sanitärarmaturen in verschiedenen Betriebsarten und mit unterschiedlichen Werten der Betriebsparameter betrieben werden können, sichert sich gegen einen unbeabsichtigten Wechsel in den Programmiermodus in hardwaremäßig aufwendigerer, aber auch etwas sicherer Weise ab. Die Schaltungsanordnung der Figur 2 enthält einen kapazitiven Sensor 210, welcher dem Sensor 110 der Figur 1 entspricht und der Auslösung des Wasserstromes dient. Zusätzlich ist ein zweiter kapazitiver Sensor 220 vorgesehen, der an einer solchen Stelle angebracht ist, daß er bei der normalen Benutzung der Sanitärarmatur nicht unbeabsichtigt anspricht. Um den kapazitiven Sensor 220 also zur Abgabe eines Ausgangssignales zu bringen, ist eine bewusste Annäherung erforderlich.

Die Ausgangssignale beider kapazitiver Sensoren 210, 220 werden einer Auswertschaltung 200 zugeführt, die in gleicher Weise wie die Auswertschaltung 100 einen programmierbaren Prozessor und einen Speicher enthält. In letzterem sind wieder, kodiert durch eine bestimmte Zahl, unterschiedliche Betriebsarten und unterschiedliche Werte verschiedener Betriebsparameter abgespeichert. Die Auswertschaltung 200 steuert erneut eine Treiberschaltung 230 an, welche ein oder mehrere Magnetventile bestromt.

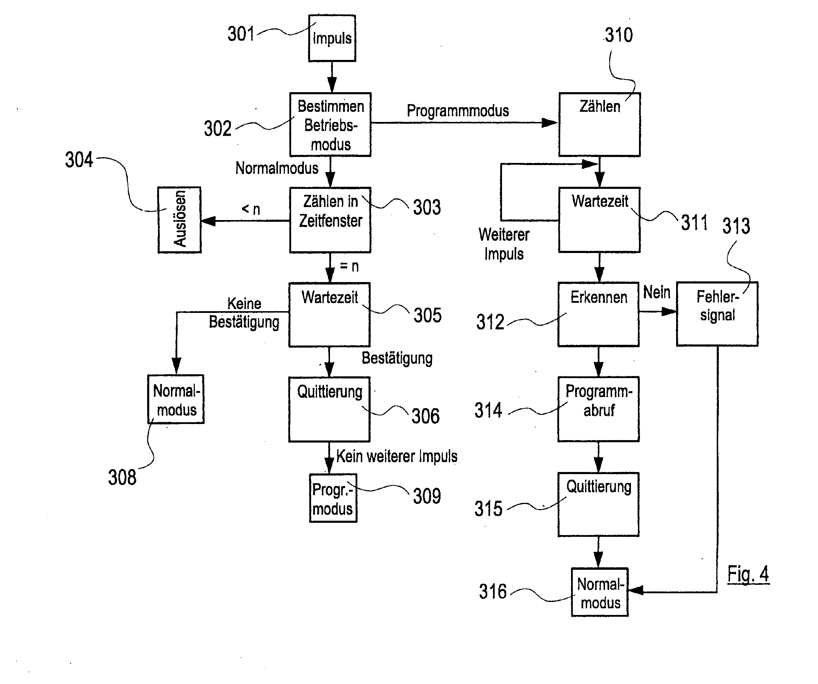

Die Abläufe in der Schaltungsanordnung der Figur 2 werden anhand der Figur 4 deutlich:

Durch den Kasten 301 wird das Auftreten eines Ausgangssignales des zur Auslösung des Wasserstromes dienenden kapazitiven Sensors 210 repräsentiert. Im Schritt 302 wird wieder differenziert, in welchem Betriebsmodus sich die Auswertschaltung 200 gerade befindet. Zunächst sei angenommen, daß es sich hierbei um den Normalmodus handelt. Ähnlich wie im Schritt 3 des in Figur 3 dargestellten Ausführungsbeispieles wird auch bei dem in Figur 4 gezeigten Ausführungsbeispiel im Schritt 303 gezählt, wie viele Impulse innerhalb eines bestimmten Zeitfensters auftreten.

Erreicht die Zahl nicht den bestimmten Wert n, der als Code für den Übergang in den Programmiermodus dient, so löst das Programm die Bestromung der Treiberschaltung 230 im Schritt 304 aus. Wird dagegen festgestellt, daß innerhalb des Zeitfensters n Impulse eingegangen sind, geht das Programm in eine Wartezeit über (Schritt 305). Wird nunmehr innerhalb dieser Wartezeit der zweite kapazitive Sensor 220 durch willentliche Annäherung eines Körperteiles betätigt, so tritt ein Bestätigungssignal auf.

Ist dies der Fall, quittiert die Schaltungsanordnung im Schritt 306 den verstandenen Befehl. Diese Quittirung kann erneut durch ein kurzzeitiges Öffnen des oder der Magnetventile der Sanitärarmatur bestehen.

Sodann geht die Auswertschaltung 200 in den Programmiermodus über. Der weitere Ablauf bei den darauf folgenden Impulsen geschieht wie beim Ausführungsbeispiel der Figur 3 über die Schritte 310 bis zum Schritt 316. Diesbezüglich kann auf die obige Beschreibung verwiesen werden.

Geht beim Schritt 305 innerhalb der dort vorgesehenen Wartezeit kein Bestätigungssignal des zweiten kapazitiven Sensors 220 ein, wechselt das Programm wieder in den Normalmodus über (Schritt 308).

Beide beschriebene Schaltungsanordnungen ermöglichen es, ohne elektrischen Zugang zu der Auswertschaltung 100, 200 herzustellen, diese nach den jeweils erforderlichen Gegebenheiten neu zu programmieren.

Bei der obigen Beschreibung wurde davon ausgegangen, daß die Treiberschaltung nur dann angesteuert wird, wenn die empfangene Impulsfolge nicht dem Impulsfolge-Code enstpricht. Unter Umständen kann es jedoch günstig sein, auch dann, wenn die empfangene Impulsfolge als Impulsfolge-Code erkannt wird, eine Auslösung der Treiberschaltung herbeizuführen. Ein solches Auslösen bleibt in diesem Falle nur aus, wenn sich die Auswertschaltung bereits im Programmiermodus befindet.

## Patentansprüche

1. Schaltungsanordnung zum Betreiben einer Sanitärarmatur mit
a) mindestens einem kapazitiven Sensor, der bei Annäherung eines Gegenstandes als Ausgangssignal einen Impuls erzeugt;
b) einer Auswertschaltung, welcher das Ausgangssignal des kapazitiven Sensors zuführbar ist und die umfasst:
ba) einen programmierbaren Prozessor;
bb) einen Speicher, auf den der Prozessor zugreifen kann und in dem unterschiedliche Betriebsarten und/oder unterschiedliche Betriebsparameter speicherbar sind;
c) einer von der Auswertschaltung angesteuerten Treiberschaltung für mindestens ein den Wasserstrom durch die Sanitärarmatur bestimmendes Magnetventil;
**dadurch gekennzeichnet, daß**
d) die Auswertschaltung (100; 200) in zwei unterschiedlichen Betriebsmoden arbeiten kann, nämlich
da) in einem Programmiermodus, in dem sie eine ihr von dem kapazitiven Sensor (110; 210) zugeführte Impulsfolge als Code für eine bestimmte im Speicher abgespeicherte Betriebsart und/oder für mindestens einen bestimmten im Speicher abgespeicherten Betriebsparameter erkennt und die Betriebsart und/oder den Betriebsparameter abruft;
db) in einem Normalmodus, in dem sie die ihr von dem kapazitiven Sensor (210; 310) zugeführte Impulsfolge auf das Vorliegen eines vorgegebenen Impulsfolge-Codes untersucht und in den Programmiermodus umwechselt, wenn der Impulsfolge-Code vorliegt, während sie bei einem Impuls oder einer Impulsfolge, die nicht dem Impulsfolge-Code entspricht, die Treiberschaltung (130; 230) entsprechend der derzeit aktiven Betriebsart und den derzeit aktiven Betriebsparametern ansteuert.

2. Schaltungsanordnung nach Anspruch 1, **dadurch gekennzeichnet, daß** der Impulsfolge-Code in einer bestimmten Anzahl von in einem bestimmten Zeitintervall auftretenden Impulsen des kapazitiven Sensors (110; 210) besteht.

3. Schaltungsanordnung nach Anspruch 1 oder 2, **dadurch gekennzeichnet, daß** Mittel vorgesehen sind, welche ausschließen, daß eine zufällig von dem kapazitiven Sensor (110; 210) erzeugte Impulsfolge als Impulsfolge-Code mißverstanden wird.

4. Schaltungsanordnung nach Anspruch 3, **dadurch gekennzeichnet, daß** die Mittel in einer Programmierung der Auswertschaltung (100) bestehen, bei welcher nach dem Zählen der von dem kapazitiven Sensor (110) innerhalb des bestimmten Zeitintervalls empfangenen Impulse mindestens eine Wartezeit eingehalten wird, in welcher das Auftreten eines weiteren Impulses überwacht wird, wobei
a) beim Auftreten eines weiteren Impulses die Treiberschaltung (130) angesteuert wird;
b) beim Ausbleiben eines weiteren Impulses in den Programmiermodus übergegangen wird.

5. Schaltungsanordnung nach Anspruch 3 oder 4, **dadurch gekennzeichnet, daß** die Mittel in einer Programmierung der Auswertschaltung (100) bestehen, bei welcher eine Wartezeit eingeschoben wird, in welcher das Auftreten eines Impulses überwacht wird, wobei
a) beim Auftreten eines weiteren Impulses in den Programmiermodus übergegangen wird;
b) beim Ausbleiben eines Impulses die Treiberschaltung (130) ausgelöst wird.

6. Schaltungsanordnung nach einem der Ansprüche 3 bis 5, **dadurch gekennzeichnet, daß** die Mittel einen zweiten kapazitiven Sensor (220) umfassen, der bei Annäherung eines Gegenstandes als Ausgangssignal einen Impuls abgibt, wobei die Auswertschaltung (200) so programmiert ist, daß sie in den Programmiermodus übergeht, wenn innerhalb einer bestimmten Wartezeit nach Erkennen des Impulsfolge-Codes ein Impuls des zweiten kapazitiven Sensors (220) auftritt, während sie die Treiberschaltung (130) ansteuert, wenn ein solcher Impuls des zweiten kapazitiven Sensors (220) ausbleibt.

7. Schaltungsanordnung nach einem der vorhergehenden Ansprüche, **dadurch gekennzeichnet, daß** die unterschiedlichen Betriebsarten und/oder die verschiedenen Betriebsparameter im Speicher über eine Zahl als Adresse abgespeichert sind und daß die Zahl der im Programmiermodus unmittelbar hintereinander auftretenden Impulse des kapazitiven Sensors (110; 210) als Code für das Auslesen der unter dieser Zahl abgespeicherten Betriebsart bzw. des unter dieser Zahl abgespeicherten Betriebsparameters verstanden wird.

8. Schaltungsanordnung nach einem der vorhergehenden Ansprüche, **dadurch gekennzeichnet, daß** die Auswertschaltung (100; 200) beim Übergang in den Programmiermodus ein Quittierungssignal erzeugt.

9. Schaltungsanordnung nach einem der vorhergehenden Ansprüche, **dadurch gekennzeichnet, daß** die Auswertschaltung (100; 200) im Programmiermodus beim Erkennen einer für eine bestimmte Betriebsart und/oder einen bestimmten Betriebsparameter codierenden Impulsfolge ein Quittierungssignal erzeugt.

10. Schaltungsanordnung nach Anspruch 8 oder 9, **dadurch gekennzeichnet, daß** das Quittierungssignal in einer bestimmten Ansteuerung der Treiberschaltung (130; 230) besteht.
